# EUROPEAN PATENT APPLICATION

(11) **EP 4 729 330 A1**
(43) Date of publication of application: **22.04.2026**
(21) Application number: 25203744.5
(22) Date of filing: 22.09.2025
(51) Int. Cl.: B60L 1/00, B60L 3/04, B60L 53/22

(54) **CONTROLLER, CHARGING SYSTEM, AND VEHICLE**

(30) Priority: 16.10.2024 JP 2024180989
(71) Applicant: TOYOTA JIDOSHA KABUSHIKI KAISHA, Toyota-shi, Aichi-ken 471-8571 (JP)
(72) Inventor: WATANABE, Yu, Toyota-shi, 471-8571 (JP)
(74) Representative: D Young & Co LLP

(57) **Abstract**

In a first inspection, a controller (50) controls a charger (100) such that one power line (PL13b) of first and second power lines is electrically connected to a first power path (PL2) and the other power line (PL13a) of the first and second power lines is electrically connected to a second power path (PL3), and determines whether or not the charger (100) is faulty based on a voltage applied to each of the first power path (PL2) and the second power path (PL3). In a second inspection, the controller (50) controls the charger (100) such that the other power line (PL13a) and the one power line (PL13b) are electrically connected to the first power path (PL2) and the second power path (PL3), respectively, and determines whether or not the charger (100) is faulty based on the voltage applied to each of the first power path (PL2) and the second power path (PL3).

## Description

### CROSS REFERENCE TO RELATED APPLICATIONS

This nonprovisional application is based on Japanese Patent Application No. 2024-180989 filed on October 16, 2024, with the Japan Patent Office, the entire contents of which are hereby incorporated by reference.

### BACKGROUND

### Field

The present disclosure relates to a controller, a charging system, and a vehicle.

### Description of the Background Art

Japanese Patent Laying-Open No. 2021-112017 discloses a charging system including: a bi-directional charger; an inlet; a vehicle interior outlet; and a C contact relay that switches between a first power path on the inlet side and a second power path on the vehicle interior outlet side. The charging system conducts an inspection of the C contact relay. In this inspection, the C contact relay and the bi-directional charger are controlled such that the C contact relay connects the bi-directional charger to the vehicle interior outlet and the bi-directional charger outputs a voltage less than 100 V to the vehicle interior outlet. When the voltage is detected at the inlet, the C contact relay is determined as being welded. When the voltage is not detected at the inlet, the C contact relay is determined as being normal. The bi-directional charger disclosed in Japanese Patent Laying-Open No. 2021-112017 functions as a bi-directional power converter.

### SUMMARY

In the inspection method disclosed in Japanese Patent Laying-Open No. 2021-112017, the bi-directional power converter outputs a voltage for inspection of the C contact relay. While the C contact relay is normal, a voltage is applied to the vehicle interior outlet and the second power path in each inspection. Such a voltage application may accelerate deterioration of the vehicle interior outlet and the second power path.

The present disclosure has been made to solve the above-described problem, and an object thereof is to accurately grasp the state of a charging system (for example, whether or not a function of switching power paths is faulty) while suppressing deterioration of the charging system resulting from an inspection.

According to a first aspect of the present disclosure, a controller described below is provided.

(Clause 1) The controller is configured to control a charger. The controller is configured to control the charger to charge a power storage device with electric power supplied from a first power path while the power storage device and the first power path are electrically connected via the charger. The controller is configured to control the charger to supply electric power to a second power path using electric power supplied from the power storage device while the power storage device and the second power path are electrically connected via the charger. The controller is configured to conduct a first inspection and a second inspection. The first inspection includes: controlling the charger such that, during application of a voltage between a first power line and a second power line in the charger by the power storage device, one power line of the first power line and the second power line is electrically connected to the first power path and the other power line of the first power line and the second power line is electrically connected to the second power path; and determining whether or not the charger is faulty based on a voltage applied to each of the first power path and the second power path. The second inspection includes: in response to a determination in the first inspection that the charger is not faulty, controlling the charger such that the other power line is electrically connected to the first power path and the one power line is electrically connected to the second power path; and determining whether or not the charger is faulty based on a voltage applied to each of the first power path and the second power path.

As described above, in each of the first and second inspections, the controller controls the charger such that one and the other of the first power line and the second power line are electrically connected to the first power path and the second power path, respectively, in which a voltage is applied by the power storage device to each of the first and second power lines. Thus, if the charger normally operates, no voltage is applied by the power storage device to each of the first and second power paths. Therefore, deterioration of the charging system (specifically, the first and second power paths) resulting from an inspection is suppressed. Further, deterioration of the charging system resulting from an inspection is thus suppressed to thereby facilitate highly frequent inspections.

On the other hand, in each of the first and second inspections, when the power storage device applies a voltage to one of the first and second power paths, the charger is regarded as not normally operating. Thus, according to the controller, the state of the charging system (in particular, whether or not a function of switching the power paths is faulty) can be accurately grasped. Further, the controller conducts the first and second inspections to make it possible to check whether or not the charger can be correctly controlled for two operation patterns of the charger. The power line connected to the first power path in the first inspection is connected to the second power path in the second inspection. The power line connected to the second power path in the first inspection is connected to the first power path in the second inspection.

According to a second aspect of the present disclosure, a charging system described below is provided.

(Clause 2) The charging system includes the controller described in Clause 1 and a charger configured to be controlled by the controller. The charger includes: a power conversion circuit; a switching device configured to switch between the first power path and the second power path; a first voltage sensor configured to detect a first voltage applied to the first power path; and a second voltage sensor configured to detect a second voltage applied to the second power path. The first voltage sensor and the second voltage sensor are configured to output a detection value of the first voltage and a detection value of the second voltage, respectively, to the controller. The power conversion circuit is configured to convert DC power supplied from the power storage device into AC power and output the AC power to the switching device. Further, the power conversion circuit is configured to convert AC power supplied from the first power path into DC power and output the DC power to the power storage device.

According to the above-described configuration, the charging system easily charges the power storage device with alternating-current (AC) power and easily feeds electric power to the first or second power path using electric power (direct-current (DC) power) of the power storage device. Further, by using the detection values from the first and second voltage sensors, the controller easily conducts the first and second inspections appropriately.

(Clause 3) In the charging system described in Clause 2, the switching device includes a first C contact relay and a second C contact relay. Each of the first C contact relay and the second C contact relay is configured to disconnect the power conversion circuit from one power path of the first power path and the second power path while connecting the power conversion circuit to the other power path of the first power path and the second power path.

The first and second C contact relays allow the switching device to appropriately switch between the first and second power paths.

(Clause 4) In the charging system described in Clause 3, the first inspection includes: controlling the charger such that the first C contact relay connects the power conversion circuit to the first power path, the second C contact relay connects the power conversion circuit to the second power path, and the power conversion circuit converts DC power supplied from the power storage device into AC power and outputs the AC power to the switching device; determining that the second C contact relay is welded when the first voltage rises as a result of the controlling in the first inspection; and determining that the first C contact relay is welded when the second voltage rises as a result of the controlling in the first inspection. The second inspection includes: controlling the charger such that the first C contact relay connects the power conversion circuit to the second power path, the second C contact relay connects the power conversion circuit to the first power path, and the power conversion circuit converts DC power supplied from the power storage device into AC power and outputs the AC power to the switching device; determining that the first C contact relay is welded when the first voltage rises as a result of the controlling in the second inspection; and determining that the second C contact relay is welded when the second voltage rises as a result of the controlling in the second inspection.

According to the above-described configuration, the controller easily grasps the states of the first and second C contact relays with accuracy by the first and second inspections.

(Clause 5) In the charging system described in Clause 4, the controller is configured to prohibit first control for supplying electric power from the first power path to the power storage device in response to each of a determination in the first inspection that the first C contact relay is welded and a determination in the second inspection that the second C contact relay is welded. The controller is configured to prohibit second control for supplying electric power from the power storage device to the second power path in response to each of a determination in the first inspection that the second C contact relay is welded and a determination in the second inspection that the first C contact relay is welded.

When it is determined in the first inspection that the first C contact relay is welded, the first C contact relay is regarded as being welded on the second power path side. When it is determined in the second inspection that the second C contact relay is welded, the second C contact relay is regarded as being welded on the second power path side. Thus, by prohibiting the first control (the control for charging of the power storage device through the first power path) as described above, a control failure can be prevented in advance.

When it is determined in the first inspection that the second C contact relay is welded, the second C contact relay is regarded as being welded on the first power path side. When it is determined in the second inspection that the first C contact relay is welded, the first C contact relay is regarded as being welded on the first power path side. Thus, by prohibiting the second control (the control for discharging of the power storage device through the second power path) as described above, a control failure can be prevented in advance.

In this way, the first and second inspections described above allow the controller to easily grasp the states of the first and second C contact relays with accuracy. Thus, based on the grasped states, the controller can prohibit prescribed control (for example, control not suitable to the grasped states).

(Clause 6) In the charging system described in Clause 3, the first inspection includes: controlling the charger such that the first C contact relay connects the power conversion circuit to the second power path, the second C contact relay connects the power conversion circuit to the first power path, and the power conversion circuit converts DC power supplied from the power storage device into AC power and outputs the AC power to the switching device; determining that the first C contact relay is welded when the first voltage rises as a result of the controlling in the first inspection; and determining that the second C contact relay is welded when the second voltage rises as a result of the controlling in the first inspection. The second inspection includes: controlling the charger such that the first C contact relay connects the power conversion circuit to the first power path, the second C contact relay connects the power conversion circuit to the second power path, and the power conversion circuit converts DC power supplied from the power storage device into AC power and outputs the AC power to the switching device; determining that the second C contact relay is welded when the first voltage rises as a result of the controlling in the second inspection; and determining that the first C contact relay is welded when the second voltage rises as a result of the controlling in the second inspection.

According to the above-described configuration, the controller easily grasps the states of the first and second C contact relays with accuracy by the first and second inspections.

(Clause 7) In the charging system described in Clause 6, the controller is configured to prohibit first control for supplying electric power from the first power path to the power storage device in response to each of a determination in the first inspection that the second C contact relay is welded and a determination in the second inspection that the first C contact relay is welded. The controller is configured to prohibit second control for supplying electric power from the power storage device to the second power path in response to each of a determination in the first inspection that the first C contact relay is welded and a determination in the second inspection that the second C contact relay is welded.

When it is determined in the first inspection that the second C contact relay is welded, the second C contact relay is regarded as being welded on the second power path side. When it is determined in the second inspection that the first C contact relay is welded, the first C contact relay is regarded as being welded on the second power path side. Thus, by prohibiting the first control (the control for charging of the power storage device through the first power path) as described above, a control failure can be prevented in advance.

When it is determined in the first inspection that the first C contact relay is welded, the first C contact relay is regarded as being welded on the first power path side. When it is determined in the second inspection that the second C contact relay is welded, the second C contact relay is regarded as being welded on the first power path side. Thus, by prohibiting the second control (the control for discharging of the power storage device through the second power path) as described above, a control failure can be prevented in advance.

In this way, the first and second inspections described above allow the controller to easily grasp the states of the first and second C contact relays with accuracy. Thus, based on the grasped states, the controller can prohibit prescribed control (for example, control not suitable to the grasped states).

(Clause 8) In the charging system described in any one of Clauses 2 to 7, the charger further includes a third voltage sensor. The third voltage sensor is configured to detect a third voltage and output a detection value of the third voltage to the controller. The third voltage is a voltage output from the power conversion circuit to the switching device. The controller is configured to determine in the first inspection that the power conversion circuit is faulty, when the third voltage does not rise even by controlling the charger such that the power conversion circuit converts DC power supplied from the power storage device into AC power and outputs the AC power to the switching device.

According to the above-described configuration, the controller easily grasps the state of the charging system (in particular, whether or not the power conversion circuit is faulty) with accuracy.

According to a third aspect of the present disclosure, a vehicle described below is provided.

(Clause 9) The vehicle includes the charging system described in Clause 4 or 5. The vehicle further includes: an AC inlet electrically connected to the first power path; and an outlet electrically connected to the second power path. The vehicle is configured to be able to execute AC charging and DC charging. In the vehicle, in AC charging, AC power supplied from an outside of the vehicle to the AC inlet is converted into DC power by the charger and the DC power is supplied to the power storage device. In the vehicle, in DC charging, DC power supplied to the vehicle from the outside of the vehicle is supplied to the power storage device without passing through the charger. The controller is configured to start the first inspection before the DC charging is started.

In general, the power storage device is charged in one scheme. Thus, AC charging and DC charging are less likely to be simultaneously performed. Further, electric power is also less likely to be discharged from the power storage device during charging of the power storage device. Thus, before DC charging is started, each of the AC inlet and the outlet is more likely to be in a disconnected state. According to the above-described configuration, when the charger does not normally operate in the first or second inspection, the voltage applied to the AC inlet or the outlet is less likely to damage an external device connected to the AC inlet or the outlet (for example, a power feeding facility connected to the AC inlet or a power load connected to the outlet).

According to a fourth aspect of the present disclosure, a vehicle described below is provided.

(Clause 10) The vehicle includes the charging system described in Clause 6 or 7. The vehicle is configured to be able to travel using electric power output from the power storage device. The vehicle further includes: an AC inlet electrically connected to the first power path; and an outlet electrically connected to the second power path. The controller is configured to start the first inspection at a start of traveling of the vehicle and/or during traveling of the vehicle.

In general, the AC inlet is used during parking. Further, while the vehicle is traveling (in particular, at the start of traveling), a user is more likely to refrain from using the outlet in order to suppress running-out of power in the power storage device. Thus, each of the AC inlet and the outlet is more likely to be in a disconnected state at the start of and during traveling of the vehicle. According to the above-described configuration, when the charger does not normally operate in the first or second inspection, the voltage applied to the AC inlet or the outlet is less likely to damage an external device connected to the AC inlet or the outlet.

The foregoing and other objects, features, aspects, and advantages of the present disclosure will become apparent from the following detailed description of the present disclosure when taken in conjunction with the accompanying drawings.

### BRIEF DESCRIPTION OF THE DRAWINGS

Fig. 1 is a diagram showing a schematic configuration of a vehicle according to an embodiment of the present disclosure.
Fig. 2 is a flowchart illustrating first inspection control according to the embodiment of the present disclosure.
Fig. 3 is a diagram showing an example of a state of a charger determined as being normal in the control in Fig. 2.
Fig. 4 is a diagram showing a first example of the state of the charger determined as being faulty in the control in Fig. 2.
Fig. 5 is a diagram showing a second example of the state of the charger determined as being faulty in the control in Fig. 2.
Fig. 6 is a diagram showing a third example of the state of the charger determined as being faulty in the control in Fig. 2.
Fig. 7 is a diagram showing a fourth example of the state of the charger determined as being faulty in the control in Fig. 2.
Fig. 8 is a diagram showing a fifth example of the state of the charger determined as being faulty in the control in Fig. 2.
Fig. 9 is a flowchart illustrating a control prohibition process according to the embodiment of the present disclosure.
Fig. 10 is a flowchart illustrating second inspection control according to the embodiment of the present disclosure.
Fig. 11 is a diagram showing an example of a state of the charger determined as being normal in the control in Fig. 10.
Fig. 12 is a diagram showing a first example of the state of the charger determined as being faulty in the control in Fig. 10.
Fig. 13 is a diagram showing a second example of the state of the charger determined as being faulty in the control in Fig. 10.
Fig. 14 is a diagram showing a third example of the state of the charger determined as being faulty in the control in Fig. 10.
Fig. 15 is a diagram showing a fourth example of the state of the charger determined as being faulty in the control in Fig. 10.
Fig. 16 is a diagram showing a fifth example of the state of the charger determined as being faulty in the control in Fig. 10.
Fig. 17 is a diagram showing a modification of the configuration of the vehicle shown in Fig. 1.

### DESCRIPTION OF THE PREFERRED EMBODIMENTS

Hereinafter, embodiments of the present disclosure will be described in detail with reference to the accompanying drawings. The same or corresponding portions in the drawings are denoted by the same reference characters, and the description thereof will not be repeated.

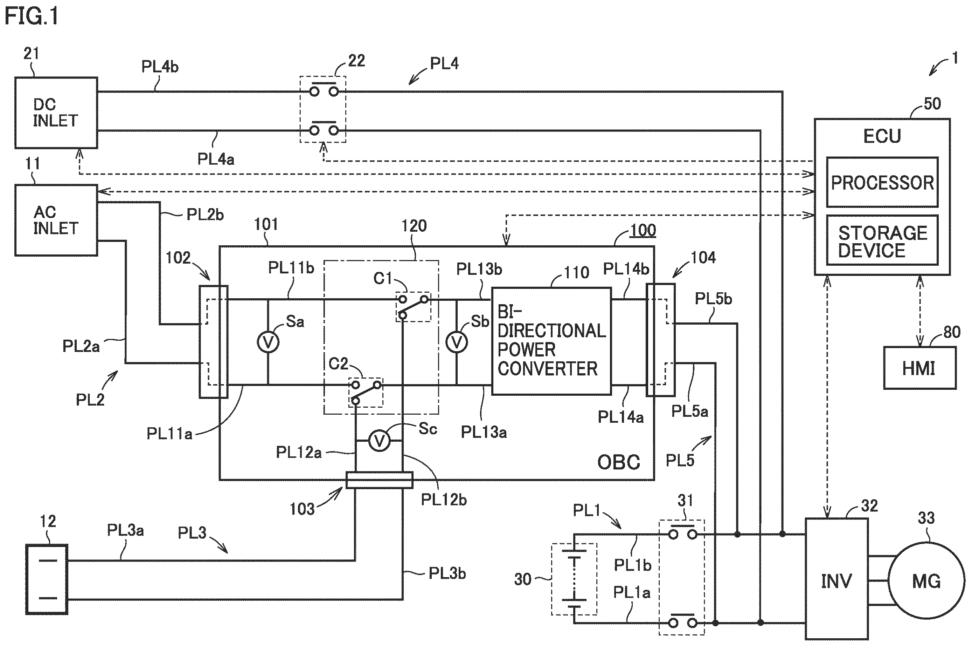

Fig. 1 is a diagram showing a configuration of a vehicle 1 according to the present embodiment. Referring to Fig. 1, vehicle 1 is, for example, a battery electric vehicle (BEV) not including an internal combustion engine. Without being limited to the above, vehicle 1 may be a plug-in hybrid electric vehicle (PHEV) including an internal combustion engine or may be another electrically powered vehicle (xEV).

Vehicle 1 includes an AC inlet 11, an outlet 12, a DC inlet 21, a relay 22, a charger 100, a battery 30, an SMR 31, an inverter 32, a motor generator (MG) 33, an ECU 50, and a human machine interface (HMI) 80. Charger 100 functions as an on-board charger (OBC). ECU 50 corresponds to an example of a "controller" according to the present disclosure. The "ECU" means an electronic control unit. The "SMR" means a system main relay.

Charger 100 includes a housing 101 and ports 102, 103, and 104 provided in housing 101. Charger 100 is configured to be electrically connectable to each of power paths PL1 to PL3 by ports 102, 103, and 104. Battery 30 is connected to power path PL1. Charger 100 is configured to be attachable to and detachable from each port. This facilitates replacement of charger 100.

A connector of power path PL2 connecting AC inlet 11 and charger 100 is connected to port 102. Power path PL2 includes a power line PL2a having the first polarity and a power line PL2b having the second polarity. Power path PL2 is electrically connected to each of AC inlet 11 and charger 100. A connector of power path PL3 connecting outlet 12 and charger 100 is connected to port 103. Power path PL3 includes a power line PL3a having the first polarity and a power line PL3b having the second polarity. Power path PL3 is electrically connected to each of outlet 12 and charger 100. A connector of a power path PL5 connecting power path PL1 and charger 100 is connected to port 104. Power path PL5 includes a power line PL5a having the first polarity and a power line PL5b having the second polarity. Power path PL5 is electrically connected to each of power path PL1 and charger 100. Power path PL1 includes a power line PL1a having the first polarity and a power line PL1b having the second polarity. Power path PL1 is electrically connected to each of battery 30 and power path PL5. Battery 30 outputs electric power for driving vehicle 1 to power path PL1. The first polarity is opposite in polarity to the second polarity. In the present embodiment, the first polarity is negative and the second polarity is positive. Without being limited to the above, the first polarity may be positive and the second polarity may be negative.

Power path PL1 extends from battery 30 to inverter 32. SMR 31 includes a pair of relays (for example, electromagnetic mechanical relays) provided on power lines PL1a and PL1b, and is configured to switch between connection and disconnection of power lines PL1a and PL1b. A power path PL4 extends from DC inlet 21 to power path PL1. Power path PL4 includes a power line PL4a having the first polarity and a power line PL4b having the second polarity. Power path PL4 is electrically connected to each of DC inlet 21 and power path PL1. Relay 22 includes a pair of relays (for example, electromagnetic mechanical relays) provided on power lines PL4a and PL4b, and is configured to switch between connection and disconnection of power lines PL4a and PL4b. Power line PL1a is connected to each of power lines PL4a and PL5a on the inverter 32 side with respect to SMR 31. Power line PL1b is connected to each of power lines PL4b and PL5b on the inverter 32 side with respect to SMR 31.

Vehicle 1 is configured to be able to travel using electric power output from battery 30. Specifically, MG 33 functions as a traveling motor, and inverter 32 functions as a drive circuit of MG 33. Electric power is supplied from battery 30 to inverter 32 through power lines PL1a and PL1b. Inverter 32 drives MG 33 using electric power output from battery 30. MG 33 converts electric power into torque to rotate driving wheels of vehicle 1. MG 33 charges battery 30 by performing regenerative power generation, for example, during deceleration of vehicle 1.

Vehicle 1 is configured to be able to perform AC charging in which AC power supplied from the outside of the vehicle to AC inlet 11 is converted by charger 100 into DC power that is then supplied to battery 30. Specifically, AC inlet 11 includes a connector lock device. When a connector of a charging cable of an AC power feeding facility external to the vehicle (the connector will be hereinafter referred to as an "AC connector") is connected to AC inlet 11, the connector lock device locks the AC connector (i.e., connector locking). Thereby, removal of the AC connector is suppressed. After the end of AC charging, locking of the AC connector is released (unlocked) by the connector lock device. This permits removal of the AC connector. Charger 100 includes a power conversion circuit 110 and a switching device 120. In the present embodiment, power conversion circuit 110 functions as a bi-directional power converter (for example, a bi-directional converter). Switching device 120 is provided at a confluence of power lines (power lines PL11a and PL11b) electrically connected to power path PL2, power lines (power lines PL12a and PL12b) electrically connected to power path PL3, and power lines (power lines PL13a and PL13b) electrically connected to power conversion circuit 110. Switching device 120 is configured to switch between connection and disconnection between power path PL2 and power conversion circuit 110. In the state in which switching device 120 selects power path PL2, power path PL2 is electrically connected to power conversion circuit 110, and power path PL3 is disconnected from power conversion circuit 110. AC charging is performed in this state.

For example, after the AC connector is connected to AC inlet 11 and connector locking is done, a prescribed inspection (an inspection before the start of power feeding) is conducted. If no abnormality is found in the inspection before the start of power feeding, AC power is supplied from the AC power feeding facility to AC inlet 11. Then, the AC power input from AC inlet 11 to port 102 is converted by power conversion circuit 110 into DC power having a prescribed voltage (for example, a voltage applicable to battery 30), and this converted DC power is then output to port 104. Thereby, DC power is output from charger 100 to battery 30, so that battery 30 is charged.

Vehicle 1 is configured to be able to perform DC charging in which the DC power supplied to vehicle 1 from the outside of vehicle 1 is supplied to battery 30 without passing through charger 100. Specifically, DC inlet 21 includes a connector lock device. When a connector of a charging cable of a DC power feeding facility external to the vehicle (this connector will be hereinafter referred to as a "DC connector") is connected to DC inlet 21, the DC connector is locked (connector locking) by the connector lock device. Thereby, removal of the DC connector is suppressed. After the end of DC charging, locking of the DC connector is released (unlocked) by the connector lock device. This permits removal of the DC connector.

For example, after the DC connector is connected to DC inlet 21 and connector locking is done, a prescribed inspection (an inspection before the start of power feeding) is performed. If no abnormality is found in the inspection before the start of power feeding, DC power is supplied from the DC power feeding facility to DC inlet 21. Then, when ECU 50 brings relay 22 into the connected state (the closed state), DC power is supplied from DC inlet 21 to battery 30 through power path PL4, so that battery 30 is charged.

Hereinafter, AC charging and DC charging may be collectively referred to as "external charging". The power feeding facility used in external charging may be electric vehicle supply equipment (EVSE) electrically connected to a power system.

Vehicle 1 is configured to be able to perform external power feeding in which DC power supplied from battery 30 to charger 100 is converted by charger 100 into AC power that is then supplied to outlet 12. Specifically, switching device 120 is configured to switch between connection and disconnection between power path PL3 and power conversion circuit 110. In the state in which switching device 120 selects power path PL3, power path PL3 is electrically connected to power conversion circuit 110, and power path PL2 is disconnected from power conversion circuit 110.

External power feeding is performed in this state. The DC power input from battery 30 to port 104 is converted by power conversion circuit 110 into AC power having a prescribed voltage (for example, a voltage applicable to outlet 12), and this converted AC power is then output to port 103. Thereby, AC power is output from charger 100 to outlet 12, to thereby allow use of outlet 12. By connecting the power load to outlet 12, the user can supply the electric power output from outlet 12 to the power load during external power feeding. Examples of the power load include lighting devices, air conditioning equipment, cooking appliances, refrigerators, and information processing units. Outlet 12 may be provided in the interior of vehicle 1. The number of outlets 12 is not limited to one and may be more than one. ECU 50 may perform external power feeding in response to a request from the user.

Relay 22, SMR 31, inverter 32, and charger 100 are controlled by ECU 50. SMR 31 is maintained in the connected state (the closed state) during each of traveling of vehicle 1, external charging, and external power feeding. ECU 50 brings relay 22 into the connected state when DC charging is started, and brings relay 22 into the disconnected state when DC charging ends.

Battery 30 applicable in this case can be a known power storage device for a vehicle (for example, a lithium ion secondary battery, a nickel-metal hydride secondary battery, or a sodium-ion secondary battery). The type of the secondary battery may be a liquid secondary battery or an all-solid secondary battery. A plurality of secondary batteries may constitute a battery assembly. An electric double layer capacitor may be adopted instead of the secondary battery. Battery 30 corresponds to an example of the "power storage device" according to the present disclosure.

In addition to power conversion circuit 110 and switching device 120 described above, charger 100 includes: power lines PL11a, PL12a, PL13a, and PL14a each having the first polarity; power lines PL11b, PL12b, PL13b, and PL14b each having the second polarity; and voltage sensors Sa, Sb, and Sc.

Switching device 120 is configured to switch between power paths PL2 and PL3. Specifically, switching device 120 includes a relay C2 having the first polarity and a relay C1 having the second polarity. Each of relays C1 and C2 is a C contact relay. As described below, each of relays C1 and C2 is configured to disconnect power conversion circuit 110 from one of power paths PL2 and PL3 while connecting power conversion circuit 110 to the other of power paths PL2 and PL3. In the present embodiment, relays C1 and C2 correspond to examples of the "first C contact relay" and the "second C contact relay", respectively, according to the present disclosure.

Power line PL11a is electrically connected to power line PL2a via port 102. Relay C2 has one end connected to power conversion circuit 110 through power line PL13a. Relay C2 has the other end connected to only one of power lines PL11a and PL12a that is selected by ECU 50. Power line PL12a is electrically connected to power line PL3a via port 103. Power conversion circuit 110 is electrically connected, through power line PL11a or PL12a connected by relay C2, to power line PL2a or PL3a of the corresponding power path. On the other hand, power conversion circuit 110 is disconnected from power line PL3a or PL2a of the power path that is not connected by relay C2. Hereinafter, connection of relay C2 to power line PL11a is referred to as a "C2 external connection". Connection of relay C2 to power line PL12a is referred to as a "C2 internal connection".

Power line PL11b is electrically connected to power line PL2b via port 102. Relay C1 has one end connected to power conversion circuit 110 through power line PL13b. Relay C1 has the other end connected to only one of power lines PL11b and PL12b that is selected by ECU 50. Power line PL12b is electrically connected to power line PL3b via port 103. Power conversion circuit 110 is electrically connected, through power line PL11b or PL12b connected by relay C1, to power line PL2b or PL3b of the corresponding power path. On the other hand, power conversion circuit 110 is disconnected from power line PL3b or PL2b of the power path that is not connected by relay C1. Hereinafter, connection of relay C1 to power line PL11b is referred to as a "C1 external connection". Connection of relay C1 to power line PL12b is referred to as a "C1 internal connection".

Power conversion circuit 110 is located between switching device 120 and port 104. Power conversion circuit 110 has one end connected to switching device 120 through power lines PL13a and PL13b. Power conversion circuit 110 has the other end connected to port 104 through power lines PL14a and PL14b. Power lines PL14a and PL14b are electrically connected to power lines PL5a and PL5b, respectively, via port 104.

When switching device 120 selects power path PL2, the "C1 external connection" and the "C2 external connection" are established. Thereby, power conversion circuit 110 is electrically connected to each of power lines PL2a and PL2b constituting power path PL2. Hereinafter, this state will be referred to as a "first switch state".

When switching device 120 selects power path PL3, the "C1 internal connection" and the "C2 internal connection" are established. Thereby, power conversion circuit 110 is electrically connected to each of power lines PL3a and PL3b constituting power path PL3. Hereinafter, this state will be referred to as a "second switch state".

Power conversion circuit 110 is configured to bi-directionally perform DC (direct current)/AC (alternating current) conversion. Power conversion circuit 110 may include an inverter and an isolation transformer. Power conversion circuit 110 is controlled to be set in one of: a stop state in which electric power is not output; a DC output state in which DC power is output to port 104; and an AC output state in which AC power is output to switching device 120. In AC charging, power conversion circuit 110 is set in the DC output state, and switching device 120 is set in the first switch state. Specifically, AC power supplied from AC inlet 11 to port 102 is input to power conversion circuit 110 through switching device 120 in the first switch state, and power conversion circuit 110 converts the AC power into DC power and outputs the converted DC power to battery 30. In external power feeding, power conversion circuit 110 is set in the AC output state, and switching device 120 is set in the second switch state. Specifically, DC power supplied from battery 30 to port 104 is input to power conversion circuit 110, and power conversion circuit 110 converts the DC power into AC power and outputs the converted AC power to switching device 120. The AC power output from power conversion circuit 110 is supplied to outlet 12 through switching device 120 in the second switch state.

As described above, switching device 120 is configured to electrically connect one of power paths PL2 and PL3 to battery 30 (power conversion circuit 110). In the inspection for charger 100 (described later), however, switching device 120 is controlled to be set in the state other than the first switch state and the second switch state. In the inspection, detection values from voltage sensors Sa, Sb, and Sc described below are used.

Voltage sensor Sa is located between port 102 and switching device 120. Voltage sensor Sa detects a voltage applied between power lines PL11a and PL11b (this voltage will be hereinafter denoted as "Va"). Va denotes a first voltage applied between power lines PL2a and PL2b on power path PL2.

Voltage sensor Sc is located between port 103 and switching device 120. Voltage sensor Sc detects a voltage applied between power lines PL12a and PL12b (this voltage will be hereinafter denoted as "Vc"). Vc denotes a second voltage applied between power lines PL3a and PL3b on power path PL3.

Voltage sensor Sb is located between switching device 120 and power conversion circuit 110. Voltage sensor Sb detects a voltage applied between power lines PL13a and PL13b (this voltage will be hereinafter denoted as "Vb"). Vb denotes a third voltage output from power conversion circuit 110 to switching device 120.

Voltage sensors Sa, Sb, and Sc are configured to output Va, Vb, and Vc, respectively, to ECU 50. Voltage sensors Sa, Sc, and Sb correspond to examples of the "first voltage sensor", the "second voltage sensor", and the "third voltage sensor", respectively, according to the present disclosure.

ECU 50 includes a processor and a storage device. The processor executes programs stored in the storage device to thereby execute various processes. However, various processes to be executed by ECU 50 may be executed only by hardware (electronic circuitry) without using software.

HMI 80 includes an input device and a notification device. Examples of the notification device include a display, a speaker, and a lamp. HMI 80 may include a touch panel display. Through HMI 80, the user may request ECU 50 to perform a process (for example, to start control related to traveling of vehicle 1, AC charging, DC charging, or external power feeding) or may input parameter values to ECU 50.

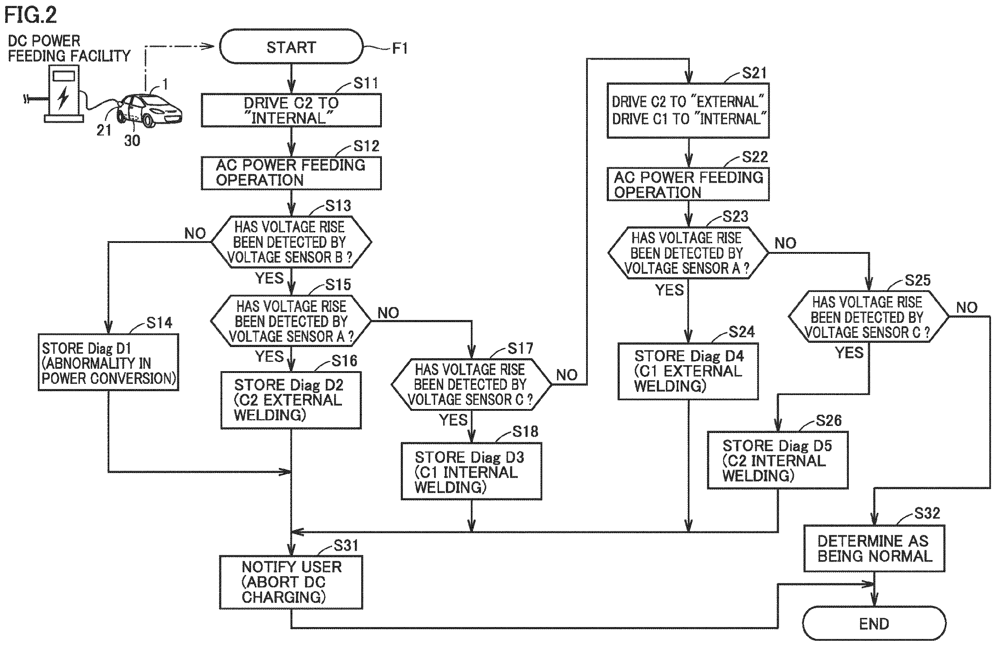

In the inspection before the start of power feeding in the DC charging sequence, ECU 50 executes the inspection control shown in Fig. 2. Fig. 2 is a flowchart illustrating the first inspection control according to the present embodiment. "S" in the flowchart denotes a step. In the present embodiment, when vehicle 1 changes from the traveling state into the parking state, ECU 50 controls SMR 31 to be set in the disconnected state, power conversion circuit 110 to be set in the stop state, and switching device 120 to be set in the first switch state. When the DC connector is connected to DC inlet 21 of vehicle 1 in the parking state and the DC connector is locked, ECU 50 brings SMR 31 into the connected state and starts a process flow F1 shown in Fig. 2. Thus, at the start of process flow F1, if charger 100 normally operates, power conversion circuit 110 is in the stop state, and switching device 120 is in the first switch state (the state of the "C1 external connection" and the "C2 external connection").

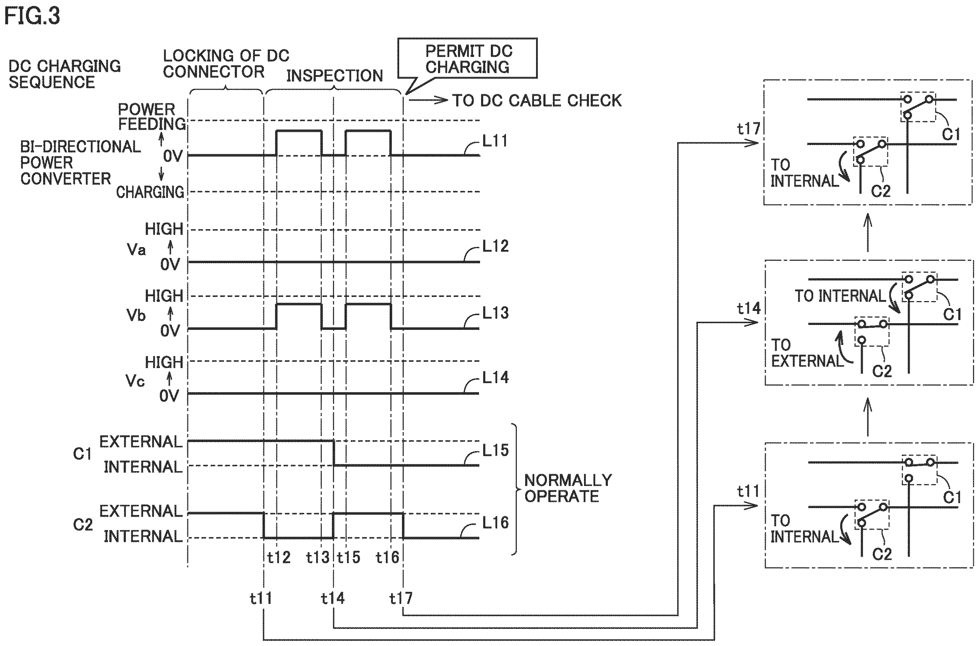

In S11, ECU 50 drives relay C2 to the "C2 internal connection". Specifically, ECU 50 transmits a control command for such driving. In subsequent S12, ECU 50 instructs power conversion circuit 110 to perform an AC power feeding operation. Specifically, ECU 50 transmits a control command to power conversion circuit 110 such that power conversion circuit 110 is set in the AC output state in a prescribed pattern (see Fig. 3 described later).

In S13, ECU 50 determines whether or not Vb has risen by the processes in S11 and S12. When Vb has not risen (NO in S13), ECU 50 performs the processes in S14 and S31, and thereafter, process flow F1 ends. Thereby, DC charging is aborted. When DC charging is aborted, the DC connector is unlocked.

In S14, ECU 50 records diagnosis information. The diagnostic information is used in a process in which the vehicle itself diagnoses whether or not it normally operates (a self-diagnosis). Hereinafter, the diagnosis information is referred to as "Diag". In S14, ECU 50 causes the storage device to store a Diag D1. Diag D1 is information indicating that power conversion circuit 110 is faulty. In this way, ECU 50 determines that power conversion circuit 110 is faulty, when Vb has not risen even though ECU 50 controls charger 100 such that power conversion circuit 110 converts the DC power supplied from battery 30 into AC power and outputs the converted AC power to switching device 120. Such a configuration allows ECU 50 to easily grasp the state of the charging system with accuracy.

In subsequent S31, ECU 50 controls HMI 80 to notify the user that an abnormality has been found. HMI 80 may notify the user about the abnormality by lighting a lamp. HMI 80 may display a message to abort the DC charging sequence due to occurrence of an abnormality in the charging system. HMI 80 may display a message to urge the user to replace the faulty charger 100. HMI 80 may display a map showing the location where charger 100 can be replaced (for example, the nearest dealer).

When Vb has risen by the processes in S11 and S12 (YES in S13), then in S15, ECU 50 determines whether or not Va has risen by the processes in S11 and S12. When Va has risen (YES in S15), ECU 50 performs the processes in S16 and S31. In S16, ECU 50 causes the storage device to store a Diag D2. Diag D2 is information indicating that relay C2 is welded in the state of the "C2 external connection". Then, the process in S31 described above is performed. Thereby, process flow F1 ends, and DC charging is aborted.

When Va has not risen by the processes in S11 and S12 (NO in S15), then in S17, ECU 50 determines whether or not Vc has risen by the processes in S11 and S12. When Vc has risen (YES in S17), ECU 50 performs the processes in S18 and S31. In S18, ECU 50 causes the storage device to store a Diag D3. Diag D3 is information indicating that relay C1 is welded in the state of the "C1 internal connection". Then, the process in S31 described above is performed. Thereby, process flow F1 ends, and DC charging is aborted.

When neither Va nor Vc has risen by the processes in S11 and S12 (NO in S17), then in S21, ECU 50 drives relay C1 to the "C1 internal connection" and drives relay C2 to the "C2 external connection". Specifically, ECU 50 transmits a control command for driving each relay in this way. The relays may be simultaneously driven or may be sequentially driven (either relay may be driven earlier). In subsequent S22, ECU 50 instructs power conversion circuit 110 to perform the AC power feeding operation. Specifically, ECU 50 transmits a control command to power conversion circuit 110 such that power conversion circuit 110 is set in the AC output state in a prescribed pattern (see Fig. 3 described later).

In S23, ECU 50 determines whether or not Va has risen by the processes in S21 and S22. When Va has risen (YES in S23), ECU 50 performs the processes in S24 and S31. In S24, ECU 50 causes the storage device to store a Diag D4. Diag D4 is information indicating that relay C1 is welded in the state of the "C1 external connection". Then, the process in S31 described above is performed. Thereby, process flow F1 ends, and DC charging is aborted.

When Va has not risen by the processes in S21 and S22 (NO in S23), ECU 50 determines in S25 whether or not Vc has risen by the processes in S21 and S22. When Vc has risen (YES in S25), ECU 50 performs the processes in S26 and S31. In S26, ECU 50 causes the storage device to store a Diag D5. Diag D5 is information indicating that relay C2 is welded in the state of the "C2 internal connection". Then, the process in S31 described above is performed. Thereby, process flow F1 ends, and DC charging is aborted.

When neither Va nor Vc has risen by the processes in S21 and S22 (NO in S25), then in S32, ECU 50 determines that charger 100 normally operates. When charger 100 is determined as being normal in S32, ECU 50 advances the DC charging sequence to the next process. The next process may be an inspection for components other than charger 100 (for example, a cable check) before the start of power feeding. On the other hand, when any one of Diag D1 to Diag D5 is recorded in the inspection of charger 100, ECU 50 aborts DC charging without proceeding with the DC charging sequence.

In the present embodiment, when charger 100 is determined as being faulty, the DC charging sequence does not proceed and DC charging is substantially prohibited. In vehicle 1 shown in Fig. 1, however, AC charging and DC charging are performed through different paths. Even if charger 100 is faulty, DC charging can still be performed. It is not essential to prohibit DC charging when charger 100 is faulty. When charger 100 is determined as being faulty, ECU 50 may continue DC charging after recording any one of Diag D1 to Diag D5. In process flow F1, S11, S12, S15, and S17 correspond to an example of the "first inspection". S21 to S23 and S25 correspond to an example of the "second inspection". As described above, the first inspection is started after the DC connector is connected to DC inlet 21 and before DC charging is started. Then, when it is determined in the first inspection that charger 100 is not faulty, the second inspection is conducted.

Fig. 3 is a diagram for illustrating the state of charger 100 that is determined as being normal in process flow F1. In this case, "t" in the time chart denotes timing. A line L11 represents a pattern of the output voltage from power conversion circuit 110. Line L11 represents the state of power conversion circuit 110 set at each timing among the stop state (0 V), the AC output state (power feeding), and the DC output state (charging). Lines L12, L13, and L14 represent transitions of Va, Vb, and Vc, respectively. Lines L15 and L16 represent transitions of the states of connection (external connection/internal connection) of relays C1 and C2, respectively.

Referring to Fig. 3, when the DC connector is locked, process flow F1 shown in Fig. 2 is executed. By the process in S11, the control of the "C2 internal connection" (see line L16) is executed at t11. By the process in S12, power conversion circuit 110 is controlled to be changed from the stop state to the AC output state at t12 and to be changed from the AC output state to the stop state at t13 (see line L11). During the time period from t12 to t13, Vb changes according to the pattern represented by line L11 (see line L13). Thus, power conversion circuit 110 is determined as being normal. During the time period from t12 to t13, ECU 50 controls switching device 120 such that, when a voltage is applied between power lines PL13a and PL13b by battery 30, power line PL13a is electrically connected to power path PL3 and power line PL13b is electrically connected to power path PL2. In the example shown in Fig. 3, during the time period from t12 to t13, Va and Vc each do not change and remain at 0 V (see lines L12 and L14). Thus, it is determined in the first inspection that charger 100 is not faulty.

Further, by the process in S21, the "C1 internal connection" and the "C2 external connection" are controlled at t14 (see lines L15 and L16). By the process in S22, power conversion circuit 110 is controlled to be changed from the stop state to the AC output state at t15 and to be changed from the AC output state to the stop state at t16 (see line L11). During the time period from t15 to t16, ECU 50 controls switching device 120 such that, when a voltage is applied between power lines PL13a and PL13b by battery 30, power line PL13a is electrically connected to power path PL2 and power line PL13b is electrically connected to power path PL3. In the example shown in Fig. 3, during the time period from t15 to t16, Va and Vc each do not change and remain at 0 V (see lines L12 and L14). Thus, it is determined also in the second inspection that charger 100 is not faulty. Thereby, DC charging is permitted. Then, at t17, the "C2 internal connection" is established, and the DC charging sequence proceeds to the next process (for example, a cable check).

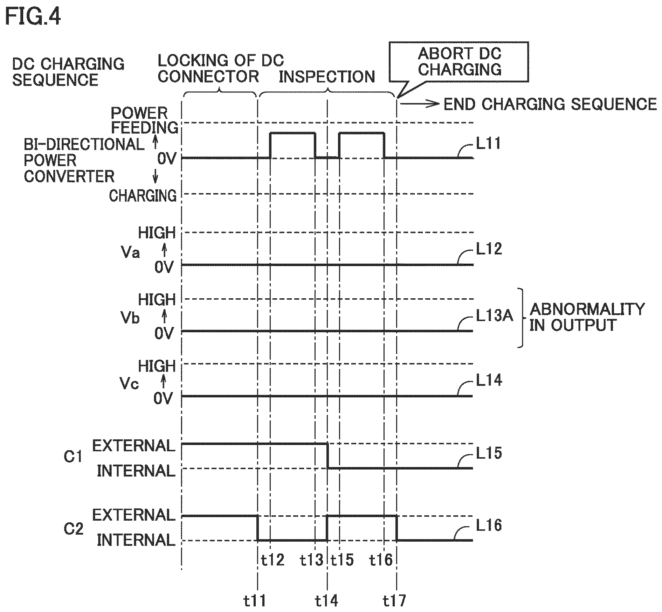

Fig. 4 is a diagram for illustrating the state of charger 100 at the time when Diag D1 is recorded in process flow F1. In the example shown in Fig. 4, as represented by a line L13A, Vb has not risen during the time period from t12 to t13 due to the fault in power conversion circuit 110. Thus, it is determined as NO in S13 in Fig. 2, and Diag D1 is recorded.

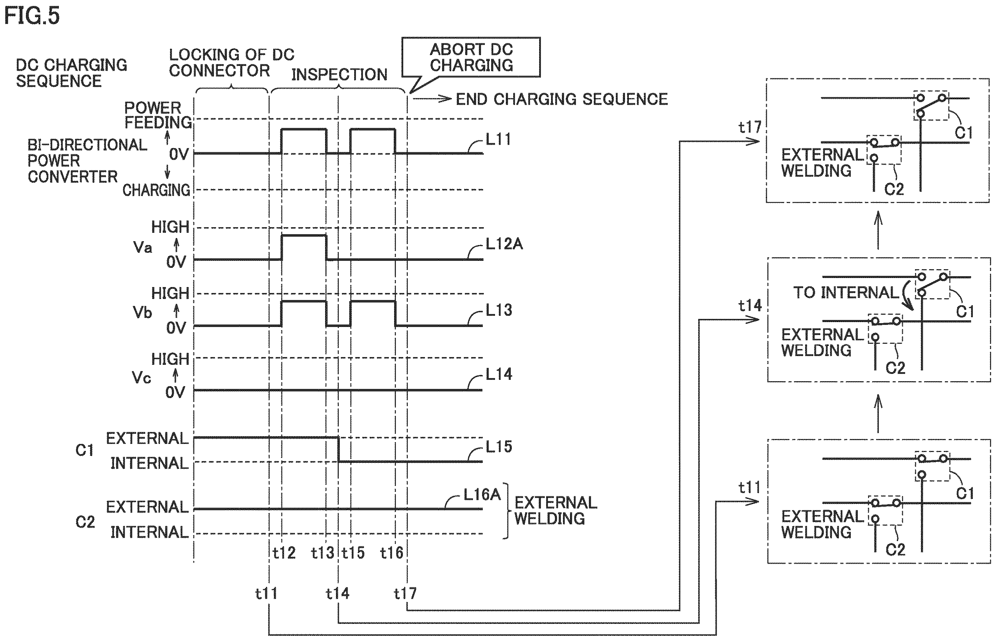

Fig. 5 is a diagram for illustrating the state of charger 100 at the time when Diag D2 is recorded in process flow F1. In the example shown in Fig. 5, as represented by a line L16A, relay C2 is welded in the state in which it is connected to power line PL11a (the state of the C2 external connection). Thus, the "C2 internal connection" is not established at t11, and Va rises during the time period from t12 to t13 (see a line L12A). Thereby, it is determined as YES in S15 in Fig. 2, and Diag D2 is recorded.

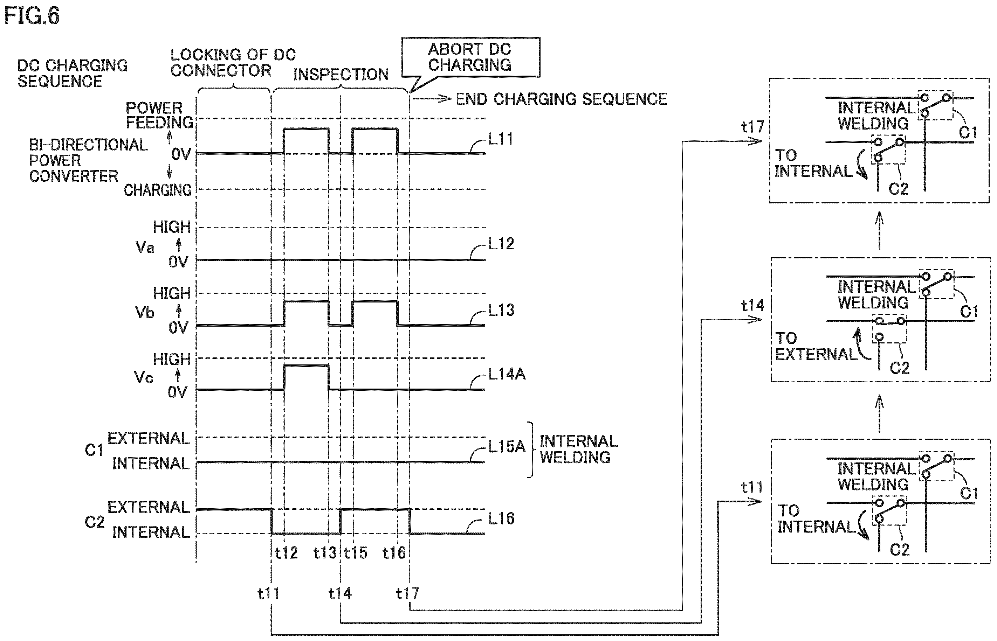

Fig. 6 is a diagram for illustrating the state of charger 100 at the time when Diag D3 is recorded in process flow F1. In the example shown in Fig. 6, as represented by a line L15A, relay C1 is welded in the state in which it is connected to power line PL12b (the state of the C1 internal connection). Thus, after the "C2 internal connection" is established at t11, Vc rises during the time period from t12 to t13 (see a line L14A). Thereby, it is determined as YES in S17 in Fig. 2, and Diag D3 is recorded.

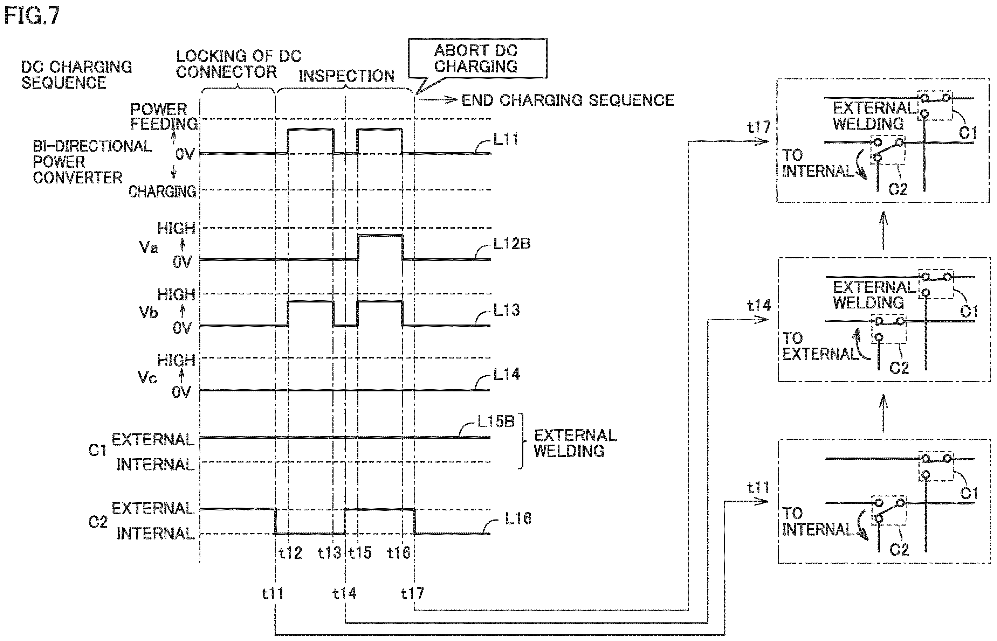

Fig. 7 is a diagram for illustrating the state of charger 100 at the time when Diag D4 is recorded in process flow F1. In the example shown in Fig. 7, as represented by a line L15B, relay C1 is welded in the state in which it is connected to power line PL11b (the state of the C1 external connection). Thus, the "C1 internal connection" is not established at t14, and Va rises during the time period from t15 to t16 (see line L12B). Thereby, it is determined as YES in S23 in Fig. 2, and Diag D4 is recorded.

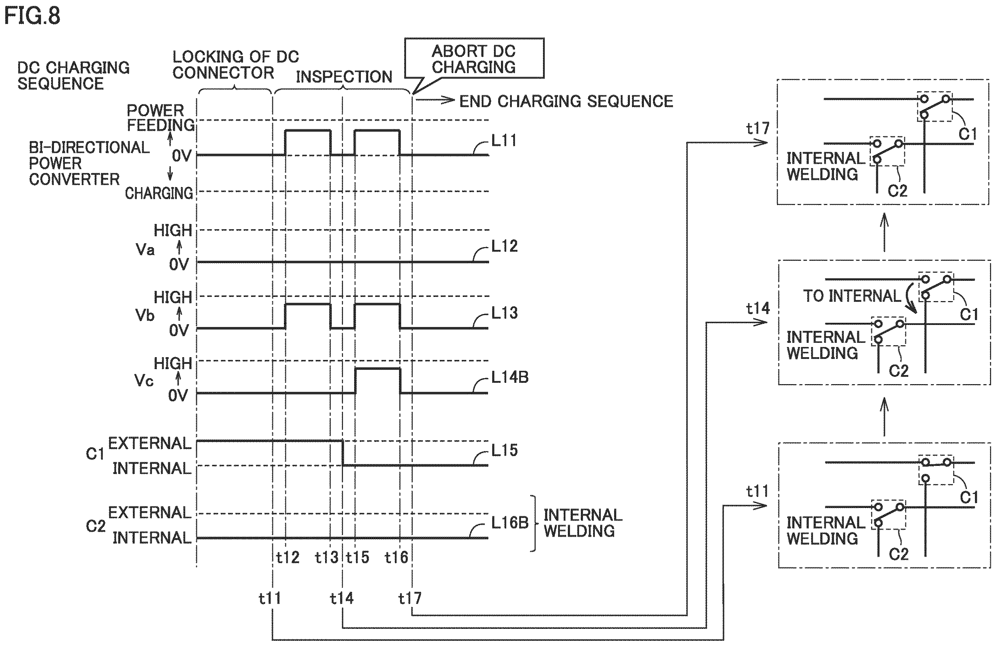

Fig. 8 is a diagram for illustrating the state of charger 100 at the time when Diag D5 is recorded in process flow F1. In the example shown in Fig. 8, as represented by a line L16B, relay C2 is welded in the state in which it is connected to power line PL12a (the state of the C2 internal connection). Thus, after the "C1 internal connection" is established at t14, Vc rises during the time period from t15 to t16 (see line L14B). Thereby, it is determined as YES in S25 in Fig. 2, and Diag D5 is recorded.

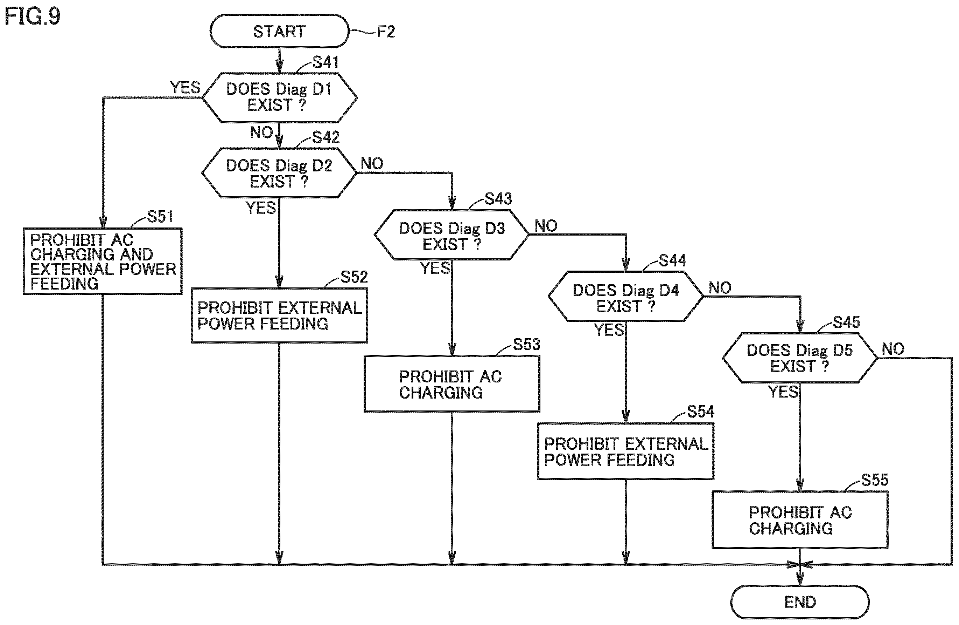

Fig. 9 is a flowchart illustrating a control prohibition process performed by ECU 50. Every time ECU 50 is activated, the activated ECU 50 executes a process flow F2 shown in Fig. 9. Further, process flow F2 is executed also when at least one of Diag D1 to Diag D5 is recorded in ECU 50 by process flow F1 shown in Fig. 2. In the initial state, none of Diag D1 to Diag D5 is recorded in ECU 50. Further, even when at least one of Diag D1 to Diag D5 is recorded in the storage device of ECU 50, Diag D1 to Diag D5 in the storage device are deleted by replacing charger 100.

Referring to Fig. 9, ECU 50 determines in S41, S42, S43, S44, and S45 whether or not Diags D1, D2, D3, D4, and D5, respectively, exist in the storage device.

When Diag D1 exists (YES in S41), then in S51, the ECU 50's control related to AC charging and external power feeding is prohibited. For example, when the user requests ECU 50 through HMI 80 to perform AC charging or external power feeding, ECU 50 rejects the request. At this time, HMI 80 may issue a notification to urge the user to replace charger 100.

When Diag D1 does not exist (NO in S41) and Diag D2 or D4 exists (YES in S42 or S44), the ECU 50's control related to external power feeding is prohibited in S52 or S54. For example, when the user requests ECU 50 through HMI 80 to perform external power feeding, ECU 50 rejects the request. At this time, HMI 80 may issue a notification to urge the user to replace charger 100.

When Diag D1 does not exist (NO in S41) and Diag D3 or D5 exists (YES in S43 or S45), the ECU 50's control related to AC charging is prohibited in S53 or S55. For example, when the user requests ECU 50 through HMI 80 to perform AC charging, ECU 50 rejects the request. At this time, HMI 80 may issue a notification to urge the user to replace charger 100.

In the present embodiment, the start condition for AC charging includes the state in which none of Diags D1, D3, and D5 is stored in ECU 50. Further, the start condition for external power feeding includes the state in which none of Diags D1, D2, and D4 is stored in ECU 50. Thus, when any one of Diags D1, D3, and D5 is stored in ECU 50, it is determined in any one of S51, S53, and S55 that the start condition for AC charging is not satisfied, and then, AC charging is prohibited. Further, when any one of Diags D1, D2, and D4 is stored in ECU 50, it is determined in any one of S51, S52, and S54 that the start condition for external power feeding is not satisfied, and then, external power feeding is prohibited. Since Diag D1 to Diag D5 are deleted upon replacement of charger 100, the processes in S51 to S55 are not performed.

Thus, the start condition for each of AC charging and external power feeding can be satisfied. For example, when other requirements (for example, completion of locking of the AC connector and determination as being normal in a cable check) in the start condition for AC charging are satisfied, AC charging is started. Without being limited to the above, when any one of Diag D2 to Diag D5 is stored in ECU 50, both AC charging and external power feeding may be prohibited.

As described above, in process flow F1 shown in Fig. 2, ECU 50 controls charger 100 such that relay C1 connects power conversion circuit 110 to power path PL2, relay C2 connects power conversion circuit 110 to power path PL3, and power conversion circuit 110 converts DC power supplied from battery 30 into AC power and outputs the converted AC power to switching device 120 (S11, S12). In such control, when Va has risen, ECU 50 determines that relay C2 is welded (S15, S16), and when Vc has risen, ECU 50 determines that relay C1 is welded (S17, S18). Further, ECU 50 controls charger 100 such that relay C1 connects power conversion circuit 110 to power path PL3, relay C2 connects power conversion circuit 110 to power path PL2, and power conversion circuit 110 converts DC power supplied from battery 30 into AC power and outputs the converted AC power to switching device 120 (S21, S22). In such control, when Va has risen, ECU 50 determines that relay C1 is welded (S23, S24), and when Vc has risen, ECU 50 determines that relay C2 is welded (S25, S26). Such an inspection allows ECU 50 to easily grasp the states of relays C1 and C2 with accuracy.

The first control (for example, AC charging control) for supplying electric power from power path PL2 to battery 30 is prohibited in S53 in Fig. 9 when relay C1 is determined as being welded in S18 or prohibited in S55 in Fig. 9 when relay C2 is determined as being welded in S26. Further, the second control (for example, external power feeding control) for supplying electric power from battery 30 to power path PL3 is prohibited in S52 in Fig. 9 when relay C2 is determined as being welded in S16, or prohibited in S54 in Fig. 9 when relay C1 is determined as being welded in S24. Thereby, a control failure can be prevented in advance.

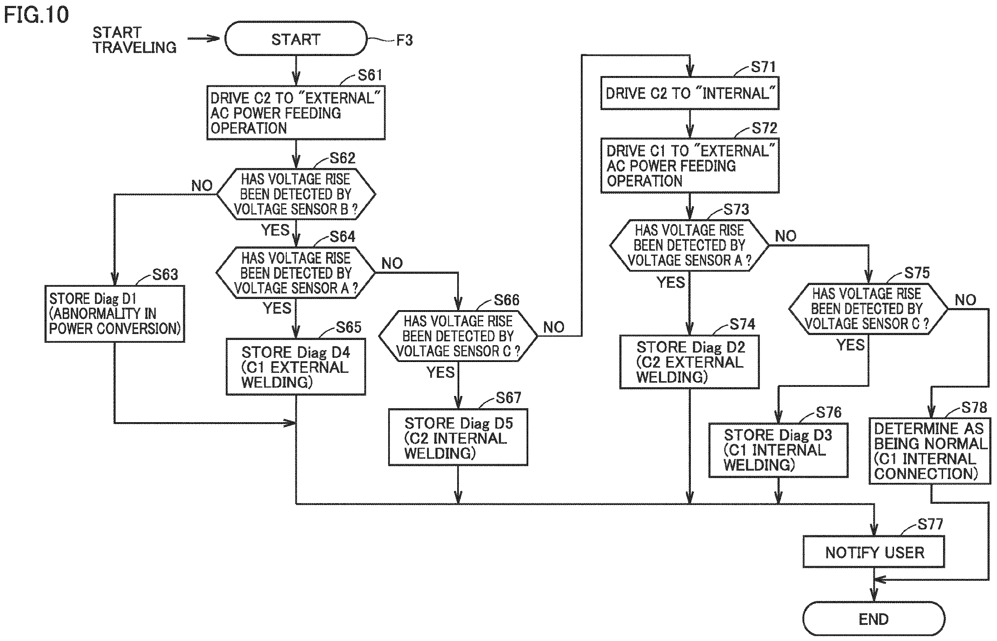

In the present embodiment, when vehicle 1 changes from the parking state to the traveling state, ECU 50 further executes the inspection control shown in Fig. 10. Fig. 10 is a flowchart illustrating the second inspection control according to the present embodiment.

For example, when the user requests vehicle 1 through HMI 80 to activate a control system (a vehicle system) of vehicle 1 while the vehicle system is stopped (including a sleep state), the vehicle system (including ECU 50) is activated. Then, the activated ECU 50 controls switching device 120 to be set in the second switch state. Further, when the user requests ECU 50 through HMI 80 to start traveling of vehicle 1, ECU 50 brings SMR 31 into the connected state such that the voltage of battery 30 is applied to inverter 32. This allows traveling of vehicle 1 by MG 33. Then, ECU 50 starts a process flow F3 shown in Fig. 10. At the start of process flow F3, if charger 100 normally operates, power conversion circuit 110 is in the stop state, and switching device 120 is in the second switch state (the state of the "C1 internal connection" and the "C2 internal connection").

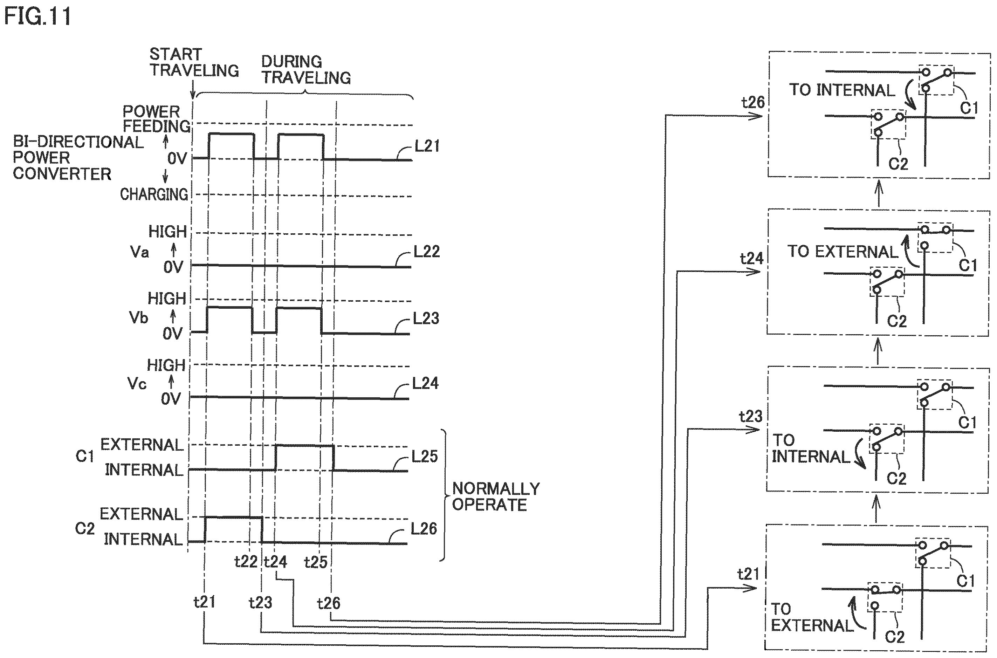

In process flow F3, in S61, ECU 50 drives relay C2 to the "C2 external connection" and instructs power conversion circuit 110 to perform the AC power feeding operation. Relay C2 and power conversion circuit 110 may be simultaneously controlled or may be sequentially controlled. ECU 50 transmits a control command to power conversion circuit 110 such that power conversion circuit 110 is set in the AC output state in a prescribed pattern (see Fig. 11 described later).

In S62, ECU 50 determines whether or not Vb has risen by the process in S61. When Vb has not risen (NO in S62), ECU 50 performs the processes in S63 and S77, and then, process flow F3 (inspection control) ends.

In S63, ECU 50 records diagnosis information. Specifically, in S63, ECU 50 causes the storage device to store Diag D1. In this way, ECU 50 determines that power conversion circuit 110 is faulty when Vb has not risen even though ECU 50 controls charger 100 such that power conversion circuit 110 converts DC power supplied from battery 30 into AC power and outputs the converted AC power to switching device 120. Such a configuration allows ECU 50 to easily grasp the state of the charging system with accuracy. Then, based on the grasped state, ECU 50 can prohibit prescribed control (for example, control not suitable to the grasped state). In the present embodiment, when power conversion circuit 110 is determined as being faulty, ECU 50 prohibits AC charging and external power feeding using charger 100 in S51 in Fig. 9.

In subsequent S77, ECU 50 controls HMI 80 to notify the user about an abnormality. HMI 80 may notify the user about the abnormality by lighting a lamp. HMI 80 may display a message indicating that an abnormality has occurred in charger 100. HMI 80 may display a message to urge the user to replace the faulty charger 100. HMI 80 may display a map showing the location where charger 100 can be replaced (for example, the nearest dealer) and the route from the current position of vehicle 1 to the location, and may guide the user to the location.

When Vb has risen by the process in S61 (YES in S62), ECU 50 determines in S64 whether or not Va has risen by the process in S61. When Va has risen (YES in S64), ECU 50 performs the processes in S65 and S77. In S65, ECU 50 causes the storage device to store Diag D4. Thereby, external power feeding (use of outlet 12) is prohibited in S54 in Fig. 9. Then, the process in S77 described above is performed, and process flow F3 (inspection control) ends.

When Va has not risen by the process in S61 (NO in S64), ECU 50 determines in S66 whether or not Vc has risen by the process in S61. When Vc has risen (YES in S66), ECU 50 performs the processes in S67 and S77. In S67, ECU 50 causes the storage device to store Diag D5. Thereby, AC charging is prohibited in S55 in Fig. 9. Then, the process in S77 described above is performed, and process flow F3 (inspection control) ends.

When neither Va nor Vc has risen by the process in S61 (NO in S66), ECU 50 drives relay C2 to the "C2 internal connection" in S71. In S72, ECU 50 subsequently drives relay C1 to the "C1 external connection", and instructs power conversion circuit 110 to perform the AC power feeding operation. Relay C1 and power conversion circuit 110 may be simultaneously controlled or may be sequentially controlled. In subsequent S73, ECU 50 determines whether or not Va has risen by the processes in S71 and S72. When Va has risen (YES in S73), ECU 50 performs the processes in S74 and S77. In S74, ECU 50 causes the storage device to store Diag D2. Thereby, external power feeding (use of outlet 12) is prohibited in S52 in Fig. 9. Then, the process in S77 described above is performed, and process flow F3 (inspection control) ends.

When Va has not risen by the processes in S71 and S72 (NO in S73), ECU 50 determines in S75 whether or not Vc has risen by the processes in S71 and S72. When Vc has risen (YES in S75), ECU 50 performs the processes in S76 and S77. In S76, ECU 50 causes the storage device to store Diag D3. Thereby, AC charging is prohibited in S53 in Fig. 9. Then, the process in S77 described above is performed, and process flow F3 (inspection control) ends.

When neither Va nor Vc has risen by the processes in S71 and S72 (NO in S75), then in S78, ECU 50 determines that charger 100 normally operates, and establishes the "C1 internal connection". Thereby, the states of relays C1 and C2 return to those before the inspection.

In process flow F3, S61, S64, and S66 correspond to an example of the "first inspection". S71 to S73 and S75 correspond to an example of the "second inspection". As described above, the first inspection is started when vehicle 1 starts traveling. When it is determined in the first inspection that charger 100 is not faulty, the second inspection is conducted. Without being limited to the above, ECU 50 may start process flow F3 at the timing when the voltage applied to power path PL1 is stabilized (i.e., while vehicle 1 is traveling) after vehicle 1 starts traveling. For example, ECU 50 may start process flow F3 when a prescribed time period elapses since ECU 50 switches SMR 31 from the disconnected state to the connected state in order to start traveling of vehicle 1. ECU 50 may execute process flow F3 every time a prescribed time period elapses during traveling of vehicle 1.

Fig. 11 is a diagram for illustrating the state of charger 100 that is determined as being normal in process flow F3. Lines L21 to L26 in Fig. 11 correspond to lines L11 to L16 in Fig. 3 on one-to-one basis.

At the start of traveling of vehicle 1 in Fig. 11, process flow F3 shown in Fig. 10 is executed. By the process in S61, the control of the "C2 external connection" (see line L26) is executed at t21. Further, power conversion circuit 110 is controlled to be changed from the stop state to the AC output state at t21 and to be changed from the AC output state to the stop state at t22 (see line L21). During the time period from t21 to t22, Vb changes according to the pattern represented by line L21 (see line L23). Thus, power conversion circuit 110 is determined as being normal. During the time period from t21 to t22, ECU 50 controls switching device 120 such that power lines PL13a and PL13b are electrically connected to power paths PL2 and PL3, respectively, when a voltage is applied between power lines PL13a and PL13b by battery 30 (see lines L23, L25, and L26). In the example shown in Fig. 11, during the time period from t21 to t22, Va and Vc each do not change and remain at 0 V (see lines L22 and L24). Thus, it is determined in the first inspection that charger 100 is not faulty.

Further, by the process in S71, the control of the "C2 internal connection" is executed at t23 (see line L26). By the process in S72, the control of the "C1 external connection" is executed at t24 (see line L25). Further, power conversion circuit 110 is controlled to be changed from the stop state to the AC output state at t24 and to be changed from the AC output state to the stop state at t25 (see line L21). During the time period from t24 to t25, ECU 50 controls switching device 120 such that power lines PL13a and PL13b are electrically connected to power paths PL3 and PL2, respectively, when a voltage is applied between power lines PL13a and PL13b by battery 30 (see lines L23, L25, and L26). In the example shown in Fig. 11, during the time period from t24 to t25, Va and Vc each do not change and remain at 0 V (see lines L22 and L24). Thus, it is determined also in the second inspection that charger 100 is not faulty, and the "C1 internal connection" is established at t26.

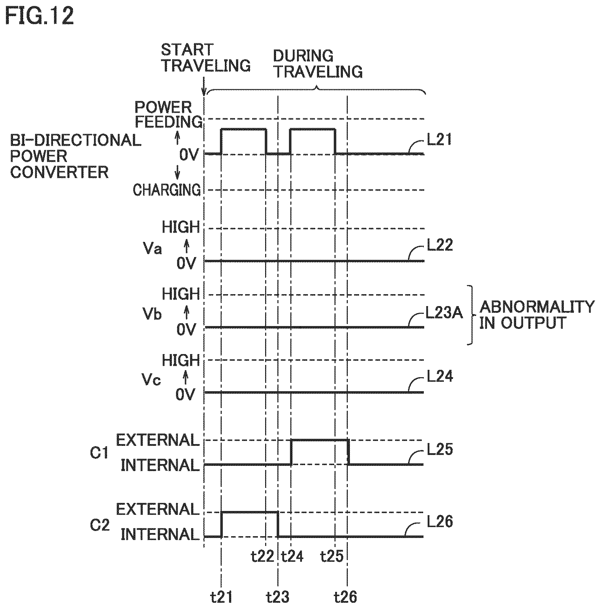

Fig. 12 is a diagram for illustrating the state of charger 100 at the time when Diag D1 is recorded in process flow F3. In the example shown in Fig. 12, as represented by a line L23A, Vb has not risen during the time period from t21 to t22 due to the fault in power conversion circuit 110. Thus, it is determined as NO in S62 in Fig. 10, and Diag D1 is recorded.

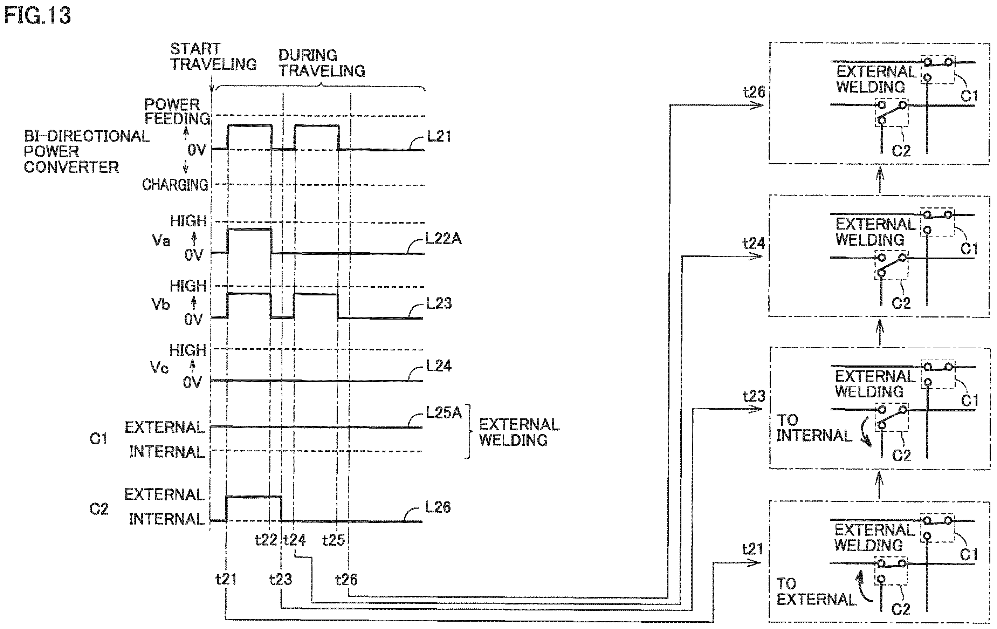

Fig. 13 is a diagram for illustrating the state of charger 100 at the time when Diag D4 is recorded in process flow F3. In the example shown in Fig. 13, as represented by a line L25A, relay C1 is welded in the state in which it is connected to power line PL11b (the state of the C1 external connection). Thus, Va rises during the time period from t21 to t22 (see a line L22A). Thereby, it is determined as YES in S64 in Fig. 10, and Diag D4 is recorded.

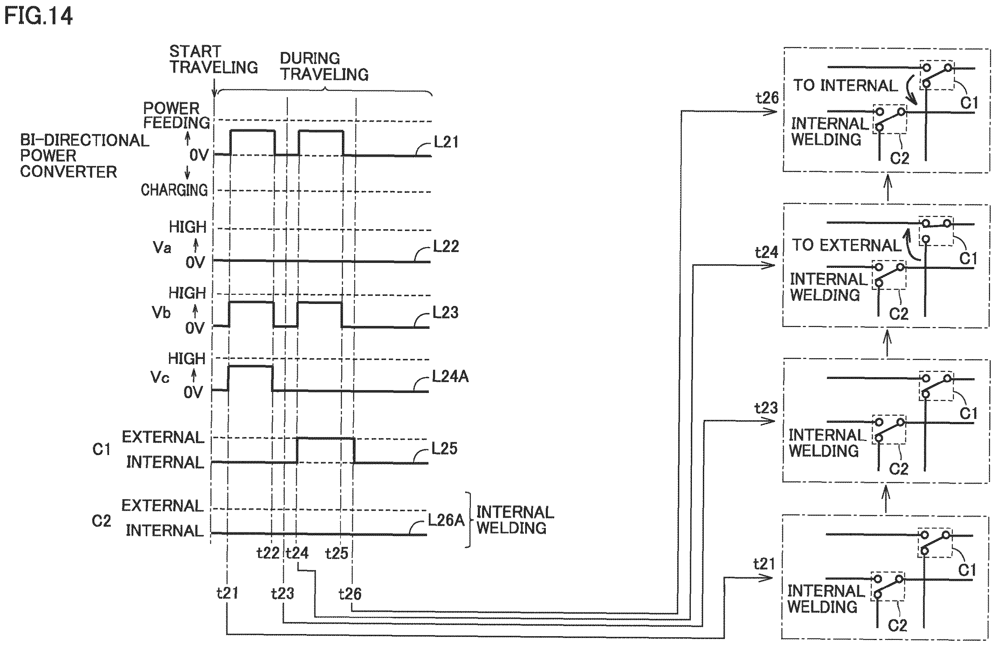

Fig. 14 is a diagram for illustrating the state of charger 100 at the time when Diag D5 is recorded in process flow F3. In the example shown in Fig. 14, as represented by a line L26A, relay C2 is welded in the state in which it is connected to power line PL12a (the state of the C2 internal connection). Thus, Vc rises during the time period from t21 to t22 (see a line L24A). Thereby, it is determined as YES in S66 in Fig. 10, and Diag D5 is recorded.

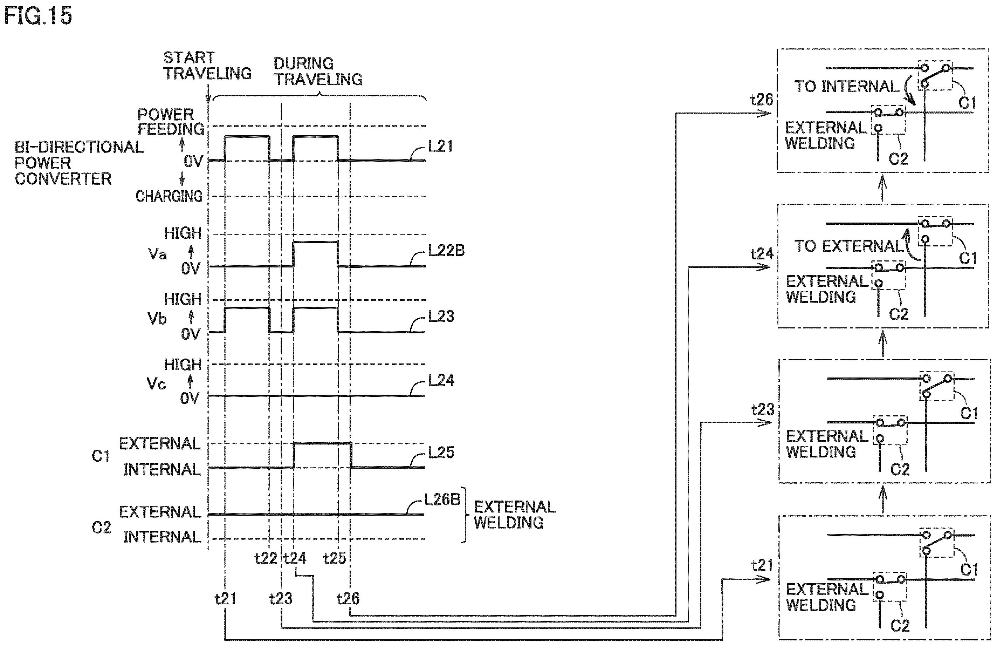

Fig. 15 is a diagram for illustrating the state of charger 100 at the time when Diag D2 is recorded in process flow F3. In the example shown in Fig. 15, as represented by a line L26B, relay C2 is welded in the state in which it is connected to power line PL11a (the state of the C2 external connection). Thus, Va rises during the time period from t24 to t25 (see a line L22B). Thereby, it is determined as YES in S73 in Fig. 10, and Diag D2 is recorded.

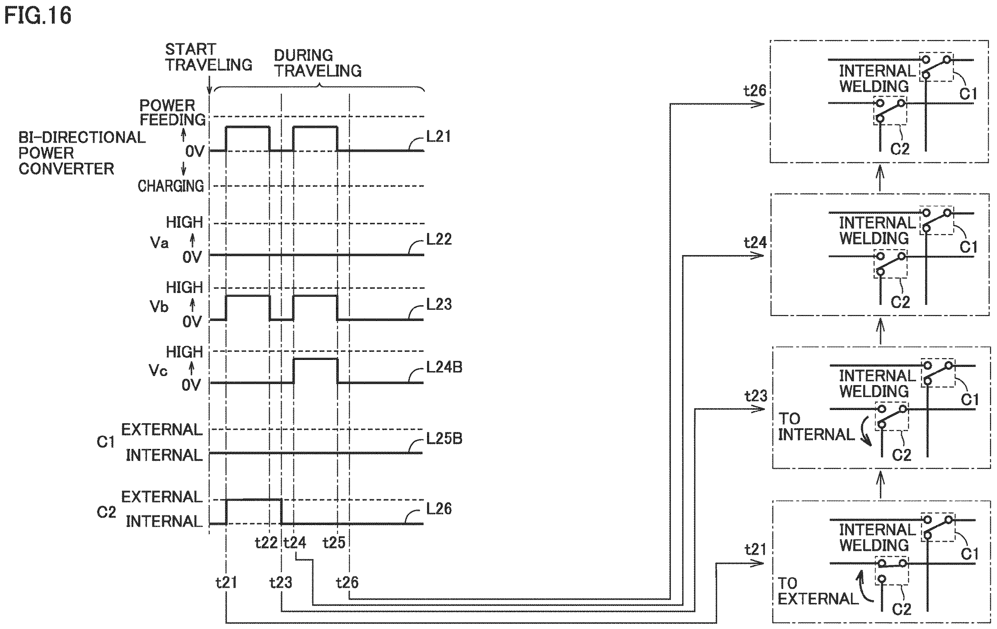

Fig. 16 is a diagram for illustrating the state of charger 100 at the time when Diag D3 is recorded in process flow F3. In the example shown in Fig. 16, as represented by a line L25B, relay C1 is welded in the state in which it is connected to power line PL12b (the state of the C1 internal connection). Thus, Vc rises during the time period from t24 to t25 (see a line L24B). Thereby, it is determined as YES in S75 in Fig. 10, and Diag D3 is recorded.

As described above, in process flow F3 shown in Fig. 10, ECU 50 controls charger 100 such that relay C1 connects power conversion circuit 110 to power path PL3, relay C2 connects power conversion circuit 110 to power path PL2, and power conversion circuit 110 converts DC power supplied from battery 30 into AC power and outputs the converted AC power to switching device 120 (S61). Then, in such control, when Va has risen, ECU 50 determines that relay C1 is welded (S64, S65), and when Vc has risen, ECU 50 determines that relay C2 is welded (S66, S67). When it is determined that both relays C1 and C2 are not welded, ECU 50 controls charger 100 such that relay C1 connects power conversion circuit 110 to power path PL2, relay C2 connects power conversion circuit 110 to power path PL3, and power conversion circuit 110 converts DC power supplied from battery 30 into AC power and outputs the converted AC power to switching device 120 (S71, S72). Then, in such control, when Va has risen, ECU 50 determines that relay C2 is welded (S73, S74), and when Vc has risen, ECU 50 determines that relay C1 is welded (S75, S76). Such an inspection allows ECU 50 to easily grasp the states of relays C1 and C2 with accuracy.

The first control (for example, AC charging control) for supplying electric power from power path PL2 to battery 30 is prohibited in S55 in Fig. 9 when relay C2 is determined as being welded in S67, or prohibited in S53 in Fig. 9 when relay C1 is determined as being welded in S76. Further, the second control (for example, external power feeding control) for supplying electric power from battery 30 to power path PL3 is prohibited in S54 in Fig. 9 when that relay C1 is determined as being welded in S65, or prohibited in S52 in Fig. 9 when relay C2 is determined as being welded in S74. Thereby, a control failure can be prevented in advance.

As described above, in the present embodiment, ECU 50 (the controller) is configured to control charger 100. During AC charging, ECU 50 controls charger 100 such that battery 30 and power path PL2 (the first power path) are electrically connected via charger 100, and charger 100 charges battery 30 using the electric power supplied from power path PL2. During external power feeding, ECU 50 controls charger 100 such that battery 30 and power path PL3 (the second power path) are electrically connected via charger 100, and charger 100 supplies electric power to power path PL3 using the electric power supplied from battery 30. ECU 50 executes process flows F1 to F3 (Figs. 2, 9, and 10). In the present embodiment, each process is performed by one or more processors executing programs stored in one or more memories. However, these processes may be executed only by hardware (electronic circuitry) without using software.

Specifically, by the processes in S11, S12, S15, and S17 in process flow F1 (Fig. 2), ECU 50 controls charger 100 such that, when a voltage is applied by battery 30 between power line PL13a (the first power line) and power line PL13b (the second power line) in charger 100, one power line (power line PL13b) of power lines PL13a and PL13b is electrically connected to power path PL2 and the other power line (power line PL13a) of power lines PL13a and PL13b is electrically connected to power path PL3, and then, determines whether or not charger 100 is faulty based on each of the voltage (Va) applied to power path PL2 and the voltage (Vc) applied to power path PL3. When it is determined in each of S15 and S17 that charger 100 is not faulty, ECU 50 performs the processes in S21 to S23 and S25 in process flow F1 (Fig. 2), to control charger 100 such that the other power line (power line PL13a) is electrically connected to power path PL2 and the one power line (power line PL13b) is electrically connected to power path PL3, and determine whether or not charger 100 is faulty based on each of the voltage (Va) applied to power path PL2 and the voltage (Vc) applied to power path PL3. According to such a configuration, the state of the charging system (in particular, whether or not charger 100 is faulty) can be accurately grasped.

Further, by the processes in S61, S64, and S66 in process flow F3 (Fig. 10), ECU 50 controls charger 100 such that, when a voltage is applied by battery 30 between power lines PL13a and PL13b in charger 100, one power line (power line PL13a) of power lines PL13a and PL13b is electrically connected to power path PL2 and the other power line (power line PL13b) of power lines PL13a and PL13b is electrically connected to power path PL3, and determines whether or not charger 100 is faulty based on each of the voltage (Va) applied to power path PL2 and the voltage (Vc) applied to power path PL3. When it is determined in each of S64 and S66 that charger 100 is not faulty, ECU 50 performs the processes in steps S71 to S73 and S75 in process flow F3 (Fig. 10) to control charger 100 such that the other power line (power line PL13b) is electrically connected to power path PL2 and the one power line (power line PL13a) is electrically connected to power path PL3, and determine whether or not charger 100 is faulty based on each of the voltage (Va) applied to power path PL2 and the voltage (Vc) applied to power path PL3. According to such a configuration, the state of the charging system (in particular, whether or not charger 100 is faulty) can be accurately grasped.

In vehicle 1 according to the above-described embodiment, AC inlet 11 is used only for charging. Without being limited to the above, however, AC inlet 11 may be used for external power feeding (power feeding from a power storage device mounted in vehicle 1 to the outside of the vehicle). Vehicle 1 may be configured to output the electric power stored in battery 30 to the outside of the vehicle through one of AC inlet 11 and outlet 12 that is selected by switching device 120. In such a configuration, when at least one of relays C1 and C2 is welded in the state of the internal connection, AC inlet 11 (power path PL2) cannot be selected by switching device 120. Further, when at least one of relays C1 and C2 is welded in the state of the external connection, outlet 12 (power path PL3) cannot be selected by switching device 120. Thus, when at least one of relays C1 and C2 is welded in the state of the internal connection, ECU 50 may prohibit external power feeding using AC inlet 11. Further, when at least one of relays C1 and C2 is welded in the state of the external connection, ECU 50 may prohibit external power feeding using outlet 12.

The configuration of the vehicle is not limited to the configuration shown in Fig. 1. For example, the configuration of the switching device may be modified. The switching device may include three or more C contact relays, and may include an A contact relay and/or a B contact relay. Further, the circuit configuration shown in Fig. 1 may be modified.

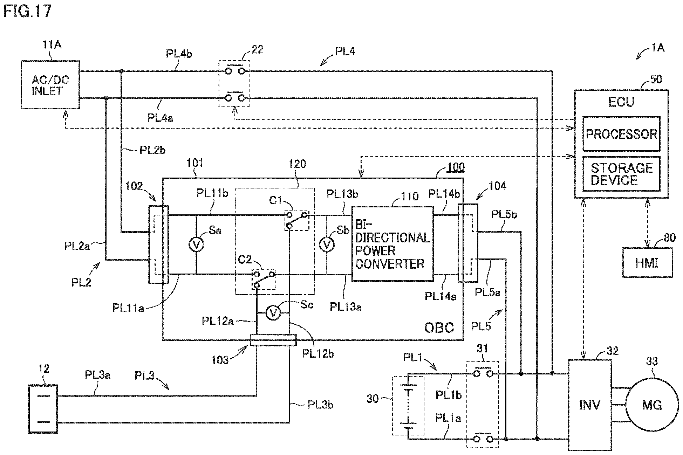

Fig. 17 is a diagram showing a modification of the configuration of the vehicle shown in Fig. 1. Referring to Fig. 17, in a vehicle 1A according to the modification, an AC/DC inlet 11A is provided instead of AC inlet 11 and DC inlet 21. AC/DC inlet 11A is an inlet common to AC charging and DC charging. Both the AC connector and the DC connector are connectable to AC/DC inlet 11A. AC/DC inlet 11A is electrically connected to each of port 102 of charger 100 and power path PL1. Specifically, power path PL2 connected to port 102 is connected to somewhere in power path PL4 (specifically, to a portion in power path PL4 that is close to AC/DC inlet 11A with respect to relay 22). During AC charging, ECU 50 controls charger 100 while maintaining relay 22 in the disconnected state. During DC charging, ECU 50 causes switching device 120 to select power path PL3 and maintains relay 22 in the connected state. When at least one of relays C1 and C2 is welded in the state of the external connection, power path PL3 cannot be selected by switching device 120. In this regard, according to process flow F1 shown in Fig. 2, DC charging is prohibited when charger 100 becomes faulty, and thereby, a control failure can be prevented in advance.

The object to which the controller is applied is not limited to a power storage system mounted in the vehicle, but the controller is applicable to any object. The controller may be applicable to a power storage system used in vehicles other than automobiles (such as railroad vehicles, ships, airplanes, and amphibious machines), movable machines (such as agricultural machines and architectural machines), unmanned movable bodies (such as automated guided vehicles (AGV), walking robots, security robots, flight drones, underwater drones, robot cleaners, and space probes), wearable robots (for example, nursing-care robots), stationary robots (for example, industrial robots), or buildings (such as houses and factories).

Process flows F1, F2, and F3 shown in Figs. 2, 9, and 10, respectively, can be modified as appropriate. For example, depending on the purpose, the order of processes may be changed or unnecessary steps may be omitted. Further, the details of any of the processes may be changed. For example, the inspection of power conversion circuit 110 (S13, S14 in Fig. 2, and S62, S63 in Fig. 10) may be omitted.

Although the embodiments of the present disclosure have been described, it should be understood that the embodiments disclosed herein are illustrative and not restrictive in every respect. The scope of the present disclosure is defined by the terms of the claims, and is intended to include any modifications within the scope and meaning equivalent to the terms of the claims.

## Claims

1. A controller (50) configured to control a charger (100), wherein
the controller (50) is configured to control the charger (100) to charge a power storage device (30) with electric power supplied from a first power path (PL2) while the power storage device (30) and the first power path (PL2) are electrically connected via the charger (100),
the controller (50) is configured to control the charger (100) to supply electric power to a second power path (PL3) using electric power supplied from the power storage device (30) while the power storage device (30) and the second power path (PL3) are electrically connected via the charger (100),
the controller (50) is configured to conduct a first inspection and a second inspection,
the first inspection includes:
controlling the charger (100) such that, during application of a voltage between a first power line (PL13a) and a second power line (PL13b) in the charger (100) by the power storage device (30), one power line (PL13b) of the first power line and the second power line is electrically connected to the first power path (PL2) and the other power line (PL13a) of the first power line and the second power line is electrically connected to the second power path (PL3); and
determining whether or not the charger (100) is faulty based on a voltage applied to each of the first power path (PL2) and the second power path (PL3), and
the second inspection includes:
in response to a determination in the first inspection that the charger (100) is not faulty,
controlling the charger (100) such that the other power line (PL13a) is electrically connected to the first power path (PL2) and the one power line (PL13b) is electrically connected to the second power path (PL3); and
determining whether or not the charger (100) is faulty based on a voltage applied to each of the first power path (PL2) and the second power path (PL3).

2. A charging system comprising:
the controller (50) according to claim 1; and
the charger (100) configured to be controlled by the controller, wherein
the charger including
a power conversion circuit (110),
a switching device (120) configured to switch between the first power path and the second power path,
a first voltage sensor (Sa) configured to detect a first voltage (Va) applied to the first power path (PL2), and
a second voltage sensor (Sc) configured to detect a second voltage (Vc) applied to the second power path (PL3), wherein
the first voltage sensor and the second voltage sensor are configured to output a detection value of the first voltage and a detection value of the second voltage, respectively, to the controller,
the power conversion circuit is configured to convert DC power supplied from the power storage device into AC power and output the AC power to the switching device, and
the power conversion circuit is configured to convert AC power supplied from the first power path into DC power and output the DC power to the power storage device.

3. The charging system according to claim 2, wherein
the switching device includes a first C contact relay (C1) and a second C contact relay (C2), and
each of the first C contact relay and the second C contact relay is configured to disconnect the power conversion circuit from one power path of the first power path and the second power path while connecting the power conversion circuit to the other power path of the first power path and the second power path.

4. The charging system according to claim 3, wherein
the first inspection includes:
controlling (S11, S12) the charger such that the first C contact relay connects the power conversion circuit to the first power path, the second C contact relay connects the power conversion circuit to the second power path, and the power conversion circuit converts DC power supplied from the power storage device into AC power and outputs the AC power to the switching device;
determining (S15, S16) that the second C contact relay is welded when the first voltage rises as a result of the controlling (S11, S12) in the first inspection; and
determining (S17, S18) that the first C contact relay is welded when the second voltage rises as a result of the controlling (S11, S12) in the first inspection, and
the second inspection includes:
controlling (S21, S22) the charger such that the first C contact relay connects the power conversion circuit to the second power path, the second C contact relay connects the power conversion circuit to the first power path, and the power conversion circuit converts DC power supplied from the power storage device into AC power and outputs the AC power to the switching device;
determining (S23, S24) that the first C contact relay is welded when the first voltage rises as a result of the controlling (S21, S22) in the second inspection; and
determining (S25, S26) that the second C contact relay is welded when the second voltage rises as a result of the controlling (S21, S22) in the second inspection.

5. The charging system according to claim 4, wherein
the controller is configured to prohibit first control for supplying electric power from the first power path to the power storage device (S53, S55) in response to each of a determination in the first inspection that the first C contact relay is welded (S18) and a determination in the second inspection that the second C contact relay is welded (S26), and
the controller is configured to prohibit second control for supplying electric power from the power storage device to the second power path (S52, S54) in response to each of a determination in the first inspection that the second C contact relay is welded (S16) and a determination in the second inspection that the first C contact relay is welded (S24).

6. The charging system according to claim 3, wherein
the first inspection includes:
controlling (S61) the charger such that the first C contact relay connects the power conversion circuit to the second power path, the second C contact relay connects the power conversion circuit to the first power path, and the power conversion circuit converts DC power supplied from the power storage device into AC power and outputs the AC power to the switching device;
determining (S64, S65) that the first C contact relay is welded when the first voltage rises as a result of the controlling (S61) in the first inspection; and
determining (S66, S67) that the second C contact relay is welded when the second voltage rises as a result of the controlling (S61) in the first inspection, and
the second inspection includes:
controlling (S71, S72) the charger such that the first C contact relay connects the power conversion circuit to the first power path, the second C contact relay connects the power conversion circuit to the second power path, and the power conversion circuit converts DC power supplied from the power storage device into AC power and outputs the AC power to the switching device;
determining (S73, S74) that the second C contact relay is welded when the first voltage rises as a result of the controlling (S71, S72) in the second inspection; and
determining (S75, S76) that the first C contact relay is welded when the second voltage rises as a result of the controlling (S71, S72) in the second inspection.

7. The charging system according to claim 6, wherein
the controller is configured to prohibit first control for supplying electric power from the first power path to the power storage device (S55, S53) in response to each of a determination in the first inspection that the second C contact relay is welded (S67) and a determination in the second inspection that the first C contact relay is welded (S76), and
the controller is configured to prohibit second control for supplying electric power from the power storage device to the second power path (S54, S52) in response to each of a determination in the first inspection that the first C contact relay is welded (S65) and a determination in the second inspection that the second C contact relay is welded (S74).

8. The charging system according to any one of claims 2 to 7, wherein
the charger further includes a third voltage sensor (Sb),
the third voltage sensor is configured to detect a third voltage (Vb) and output a detection value of the third voltage to the controller,
the third voltage is a voltage output from the power conversion circuit to the switching device, and
the controller is configured to determine in the first inspection that the power conversion circuit is faulty, when the third voltage does not rise even by controlling the charger such that the power conversion circuit converts DC power supplied from the power storage device into AC power and outputs the AC power to the switching device (S63).

9. A vehicle (1) comprising the charging system according to claim 4 or 5, the vehicle comprising:
an AC inlet (11) electrically connected to the first power path; and
an outlet (12) electrically connected to the second power path, wherein
the vehicle is configured to be able to execute
AC charging in which AC power supplied from an outside of the vehicle to the AC inlet is converted into DC power by the charger and the DC power is supplied to the power storage device, and
DC charging in which DC power supplied to the vehicle from the outside of the vehicle is supplied to the power storage device without passing through the charger, and
the controller is configured to start the first inspection before the DC charging is started.

10. A vehicle (1) comprising the charging system according to claim 6 or 7,
the vehicle being configured to be able to travel using electric power output from the power storage device,
the vehicle comprising:
an AC inlet (11) electrically connected to the first power path; and
an outlet (12) electrically connected to the second power path, wherein
the controller is configured to start the first inspection at a start of traveling of the vehicle and/or during traveling of the vehicle.
